Europäisches Patentamt

European Patent Office

Office européen des brevets

(11) Numéro de publication : **0 308 331 B1**

(19)

## (12) FASCICULE DE BREVET EUROPEEN

(45) Date de publication du fascicule du brevet :
**25.03.92 Bulletin 92/13**

(51) Int. Cl.$^5$ : **H05K 5/02**

(21) Numéro de dépôt : **88402324.3**

(22) Date de dépôt : **15.09.88**

---

(54) **Cartouche de mémoire pour équipement électronique, et équipement électronique pourvu de telles cartouches.**

---

(30) Priorité : **18.09.87 FR 8712974**

(43) Date de publication de la demande :
**22.03.89 Bulletin 89/12**

(45) Mention de la délivrance du brevet :
**25.03.92 Bulletin 92/13**

(84) Etats contractants désignés :
**BE DE ES GB IT NL SE**

(56) Documents cités :
**FR-A- 2 356 985**
**FR-A- 2 478 883**
**US-A- 3 140 905**

(73) Titulaire : **TELEMECANIQUE**
**43-45, Boulevard Franklin Roosevelt**
**F-92500 Rueil Malmaison (FR)**

(72) Inventeur : **Jullien, Claude**
**248, Chemin des Gourettes Mouans**
**F-06370 Sartoux (FR)**

(74) Mandataire : **Martin, Jean-Jacques et al**
**Cabinet REGIMBEAU 26, Avenue Kléber**
**F-75116 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

EP 0 308 331 B1

## Description

La présente invention a trait d'une façon générale aux cartouches de mémoire pour des équipements électroniques tels que des automates programmables, et concerne plus particulièrement une cartouche de mémoire amovible du type comprenant un boîtier, une unité de mémoire montée dans le boîtier et un connecteur allongé fixé au boîtier, permettant l'interconnexion de ladite unité de mémoire avec l'équipement électronique et contribuant en même temps à la fixation de la cartouche dans un logement associé de l'équipement, et des moyens de préhension prévus sur le boîtier pour permettre l'extraction de la cartouche par séparation du connecteur.

Un automate programmable comporte de façon classique une ou plusieurs de ces cartouches. Par exemple, une première cartouche peut comporter une mémoire morte contenant un programme dit "système", c'est-à-dire un programme définissant un langage spécifique pour les instructions de programmation de l'automate, tandis qu'une seconde cartouche comporte, dans une mémoire vive, un programme dit "utilisateur" qui comporte, dans le langage considéré, l'ensemble d'instructions adaptées au processus auquel est associé l'automate.

Dans une variante, la ou les mémoires mortes peuvent être remplacées par des mémoires vives sauvegardées.

On connaît déjà par le brevet français FR-A-2 502 357 un automate programmable comprenant une cartouche du type exposé en introduction.

La cartouche comporte un boîtier essentiellement rectangulaire reçu dans un logement de la face avant de l'automate, et deux ailes latérales solidaires du boîtier et saillantes vers l'extérieur permettent la préhension du boîtier aux fins d'extraction en vue du remplacement de la cartouche.

Mais une cartouche de ce type présente un certain nombre d'inconvénients.

Tout d'abord, les ailes occupant toute la hauteur du boîtier, il existe une variété de placements possibles pour les doigts de l'opérateur, et l'effort d'extraction risque de ne pas s'exercer au droit du connecteur de la cartouche. En conséquence, il se crée un couple de torsion, avec un risque substantiel de coincer la cartouche dans son logement par rotation autour d'un axe passant par le connecteur, et de tordre les broches du connecteur pour le rendre ainsi inutilisable.

En outre, une telle solution a pour autre inconvénient d'accroître l'encombrement non seulement de la cartouche en tant que telle, mais également de l'espace libre qu'il faut lui réserver sur l'automate. Plus précisément, non seulement les ailes de préhension doivent être en avant du plan de la face antérieure de l'automate, mais des espaces libres doivent être laissés de part et d'autre de ces ailes pour le positionnement des doigts.

Il en résulte notamment qu'il est impossible de juxtaposer intimement côte-à-côte deux cartouches de la technique antérieure, ce qui est encore désavantageux du point de vue de l'encombrement.

On connaît en outre par le brevet français FR-A-2 478 883 un système dans lequel des moyens de retenue et d'extraction d'une cartouche sont prévus sur l'unité qui reçoit la cartouche et non sur la cartouche elle-même et comportent un mécanisme complexe fonctionnellement associé à une porte articulée.

Le brevet US-A-3 140 905 décrit un système d'extraction opérant selon un principe analogue, appliqué à des chassis d'appareils électroniques.

Ces systèmes sont cependant complexes, fragiles et onéreux.

La présente invention vise à pallier les inconvénients de la technique antérieure et à proposer une cartouche de mémoire pour un équipement tel qu'un automate programmable, qui comporte des moyens d'extraction tels que l'effort d'extraction s'exerce toujours au droit du connecteur, et qui présente simultanément un encombrement minimal tant en profondeur qu'en hauteur et en largeur.

A cet effet, la cartouche selon l'invention présente les particularités exposées dans la partie caractérisante de la revendication 1.

Des aménagements préférés de la présente invention sont exposés ci-dessous.

De façon préférée, le boîtier est de forme essentiellement rectangulaire et le connecteur est disposé le long de l'un de ses bords horizontaux.

Dans une première réalisation de base, l'organe plat est constitué par un volet ayant une largeur sensiblement égale à celle du boîtier et une hauteur légèrement inférieure, et des liaisons pivotantes autour d'axes par exemple horizontaux sont prévues entre le volet et les faces latérales du boîtier au voisinage des extrémités respectives du connecteur.

Il est alors avantageux que le volet comprenne sur au moins l'une de ses surfaces, et de préférence sur sa surface qui, dans la première position, est cachée, une zone de préhension comportant des reliefs.

Préférentiellement, une région de la face avant du boîtier, située en vis-à-vis du volet lorsque celui-ci occupe ladite première position, tient lieu de support d'informations.

Dans ce cas, ou bien le volet est transparent, ou bien la face extérieure du volet tient lieu également de support d'informations.

Dans une seconde réalisation de base, l'organe plat est constitué par une anse en forme générale de "U", et des liaisons pivotantes sont prévues entre les extrémités libres des branches du "U" et les faces latérales du boîtier au voisinage des extrémités respectives du connecteur.

Des détails d'exécution peuvent être les suivants :

– les paliers comportent une surface extérieure à profil de came qui coopère avec un élément formant patin monté fixe dans ledit logement, de telle sorte que le passage de l'organe plat de sa première à sa seconde position engendre entre le boîtier et l'équipement un effort de poussée déterminant une phase initiale de l'extraction,

– lesdits axes et lesdits paliers sont reçus dans des renfoncements formés dans les faces latérales du boîtier, de manière à ne pas déborder audelà desdites faces latérales,

– l'organe plat et le boîtier comportent des moyens de verrouillage élastique mutuel dudit organe plat dans ladite première position,

– l'organe plat comporte une encoche offrant une zone de prise pour un ongle ou un outil en vue du déverrouillage desdits moyens de verrouillage élastique.

L'invention concerne également un équipement électronique, tel qu'un automate programmable, caractérisé en ce qu'il comprend, dans un boîtier, au moins un logement équipé d'un connecteur, dans lequel est reçue étroitement une cartouche telle que définie ci-dessus.

Des aménagements préférés de l'équipement sont les suivants :

– des moyens de verrouillage élastique mutuel sont prévus entre le boîtier de la cartouche et au moins une paroi du logement,

– il comprend un logement unique qui reçoit côte-à-côte deux cartouches,

– des moyens de guidage et de positionnement complémentaires sont prévus sur le boîtier de la cartouche et sur les parois du logement,

– les moyens de guidage et de positionnement comprennent des gorges prévues aux coins de chaque boîtier de cartouche et des nervures complémentaires formées sur les parois du logement, dont certaines sont communes aux deux cartouches.

D'autres aspects et avantages de la présente invention apparaîtront mieux à la lecture de la description détaillée suivante de modes de réalisation préférés de celle-ci, donnée à titre d'exemple et faite en référence aux dessins annexés, sur lesquels :

– la figure 1 est une vue en perspective d'une cartouche selon un premier mode de réalisation préféré de l'invention, en face d'un logement pour celle-ci prévu dans un équipement associé,

– la figure 2 est une vue en coupe verticale transversale de la cartouche de la figure 1, mise en place dans son logement,

– la figure 3 est une vue en coupe semblable à la figure 2, pendant l'extraction de la cartouche,

– les figures 4a et 4b sont des vues en coupe d'un détail d'une première variante de réalisation de l'invention,

– la figure 5 est une vue en perspective d'une seconde variante de réalisation de l'invention, et

– la figure 6 est une vue de face du logement d'un équipement électronique pouvant être équipé de deux cartouches conformes à l'invention.

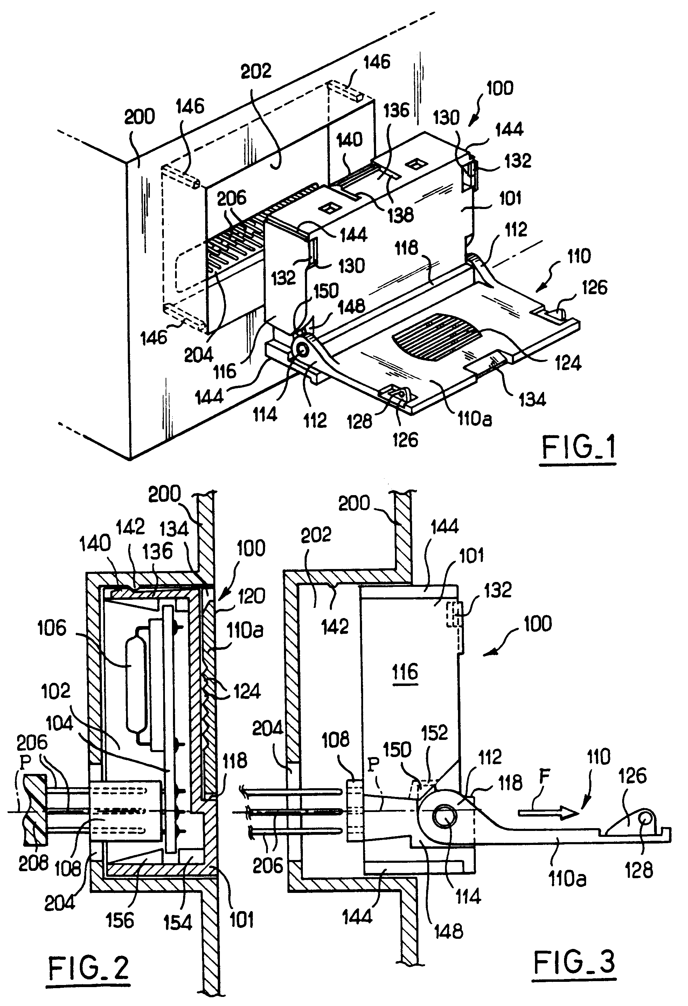

En référence tout d'abord aux figures 1 à 3, une cartouche conforme 100 conforme à un premier aspect de l'invention comprend tout d'abord un boîtier 101, de forme essentiellement rectangulaire, dont la face postérieure est ouverte pour définir une cavité 102 tournée vers l'arrière.

Dans la cavité 102 est monté verticalement un circuit imprimé 104, fixé par exemple par clipsage ou vissage, sur lequel est soudée une unité de mémoire électronique 106, par exemple une mémoire morte programmable (PROM) sous forme d'un boîtier à broches latérales de type tout à fait classique.

Sur le circuit imprimé 104 est également soudé un connecteur multibroches allongé 108, dans le présent exemple un connecteur femelle, qui est placé de manière à s'étendre essentiellement le long du bord inférieur du boîtier 100, parallèlement à celui-ci.

Le connecteur 108 a pour objet de connecter la mémoire 106 à une unité centrale (non représentée) d'un équipement électronique 200, tel qu'un automate programmable.

Ainsi, la mémoire 106 peut être une mémoire dite "système", dont le changement permet de passer d'un type de programmation d'instructions (langage) ou d'un type de fonctionnement (ensemble d'instructions disponibles) à un autre, ou encore une mémoire dite "programme", qui contient un jeu d'instructions données programmées par l'utilisateur.

Conformément à la présente invention, un volet 110 est monté pivotant dans la région inférieure du boîtier 100, et comprend à cet effet deux paliers d'extrémité 112 en saillie sensiblement dans le prolongement du corps plat du volet. Les paliers 112 reçoivent des axes horizontaux 114 qui font saillie dans la région inférieure des bords latéraux respectifs 116 du boîtier.

On peut observer que le corps plat 110a du volet occupe une hauteur légèrement inférieure à celle du boîtier 100, et que ledit boîtier comporte sur sa face avant, légèrement au-dessus des axes 114, 114', un décrochement 118. De la sorte, lorsque le volet est en position fermée, comme on le verra en détail par la suite, la partie inférieure de la face avant du boîtier est en affleurement avec la face extérieure 120 du volet (figure 2).

On a représenté sur la figure 1 un logement 202 qui est formé dans le boîtier 200 d'un équipement électronique tel qu'un automate programmable pour processus industriel ou analogue. Le logement 202 a des dimensions sensiblement égales à celles du boîtier 100 de la cartouche, de telle sorte que cette dernière peut y être encastrée avec sa face avant en affleurement.

Une ouverture 204 est formée au fond du logement pour laisser passer horizontalement l'ensemble des broches mâles 206 d'un connecteur 208 destiné à recevoir le connecteur de la cartouche. Comme on le voit sur la figure 2, l'ouverture 204 peut également recevoir l'extrémité libre (postérieure) dudit connecteur femelle 108.

La cartouche représentée sur les figures 1 à 3, ainsi que la partie associée de l'automate programmable, comportent en outre les aménagements de détail décrits ci-dessous.

Tout d'abord, une zone d'empreintes 124 destinés à améliorer la préhension du volet par les doigts de l'utilisateur aux fins d'extraction, comme on le verra en détail plus loin, est prévue sensiblement au centre de la face intérieure du corps plat 110a du volet. Ces empreintes peuvent être de section triangulaire.

En outre, dans les coins supérieurs (en position fermée) dudit corps 110a sont prévus, en saillie vers l'intérieur, deux ergots de verrouillage constitués par des parties triangulaires 126 comportant à leur surface extérieure des bossages sphériques 128. En association avec ces ergots sont prévues, dans les coins supérieurs de la face avant du boîtier 100, deux ouvertures rectangulaires 130 pourvues latéralement de rampes à double pente 132 qui constituent vis-à-vis des bossages 128 des points durs dont le franchissement assure le verrouillage du volet 110 dans sa position fermée telle qu'illustrée sur la figure 2.

Sensiblement au milieu du bord d'extrémité supérieure du volet 110 est prévue une encoche 134 qui permet, à l'aide de l'ongle, de libérer ledit volet par déverrouillage des ergots 126.

Par ailleurs, le boîtier 100 comporte, sur chacune de ses faces supérieure et inférieure, une languette souple 136 obtenue en pratiquant dans ladite face deux entailles parallèles 138 et en diminuant l'épaisseur de la matière dans cette région.

La languette comporte à son extrémité libre, sur sa face extérieure, un bourrelet 140 apte à venir s'engager par élasticité derrière un bourrelet associé 142 prévu dans la face homologue du logement 202 de l'équipement associé. Cette coopération assure, conjointement avec l'effet de maintien procuré par l'assemblage des connecteurs mâle et femelle, un verrouillage de la cartouche dans on logement.

En outre, on peut observer que des gorges 144 de section carrée sont formées aux quatre coins du boîtier 100, sur la majeure partie de la profondeur de ce dernier, en étant ouvertes à leur extrémité arrière respective. Ces gorges 144 sont destinées à coopérer avec des nervures carrées homologues 146 (figure 1) formés aux quatre coins du logement 202 pour assurer le guidage du boîtier lorsqu'il est inséré dans le logement et extrait de celui-ci.

De plus, lorsque plusieurs boîtiers sont disposés côte-à-côte dans un logement commun de grande largeur, de telles nervures 146 permettent avantageusement de positionner le boîtier correctement pour que les connecteurs mâle et femelle soient dans une relation de vis-à-vis permettant leur assemblage.

On peut indiquer également que des renfoncements 148 sont prévus de part et d'autre du boîtier 100 dans la région des axes. Ces évidements, en recevant les axes et les paliers associés, permettent d'éviter que ces éléments ne fassent saillie latéralement au-delà des parois du boîtier, ce qui permet d'en minimiser l'encombrement et de juxtaposer plusieurs cartouches, le cas échéant, sans perte de place.

Par ailleurs, comme le montre en particulier la figure 3, on peut observer que chacun des paliers du volet possède, en une position angulaire déterminée, un doigt aplati 150 qui, lorsque le volet est en position ouverte, vient se loger dans une cavité plate associée 152 formée dans une paroi du renfoncement susmentionné. Ainsi, le palier est bloqué contre toute translation le long de l'axe et l'on évite qu'un effort excessif exercé sur le volet 110 vienne inopinément désolidariser les paliers et les axes.

Enfin, on peut noter le mode de fixation du circuit imprimé 104 dans la cavité associée 102 du boîtier : celui-ci vient en appui contre quatre pieds de positionnement 154 après avoir franchi à force quatre rampes associées 156, comme le montre bien la figure 2.

L'utilisation de la cartouche décrite ci-dessus va être exposée ci-après, en référence toute particulière aux figures 2 et 3.

Sur la figure 2, la cartouche 100 est en place dans son logement 202. Elle y est maintenue fermement d'une part, par l'assemblage des connecteurs mâle et femelle 208, 108, et d'autre part, par l'action de verrouillage des languettes souples supérieure et inférieure 136.

Lorsqu'un opérateur souhaite extraire la cartouche 100 de son logement 202, par exemple aux fins de remplacement de celle-ci par une autre cartouche comportant une mémoire de contenu différent, il libère le volet 110 à l'aide de son ongle pénétrant dans l'encoche 134 (ce qui exige un effort relativement modéré); le volet, une fois libéré, est amené dans la position représentée sur la figure 3, c'est-à-dire sensiblement dans le plan horizontal d'assemblage et de séparation des connecteurs 108, 208.

Les axes 114 par lesquels le volet 110 est attaché au boîtier 100 sont situés sensiblement au niveau du plan médian P des connecteurs 108, 208.

Ainsi, lorsqu'une traction est exercée par l'opérateur sur le volet 110, en utilisant avantageusement la zone de préhension 124 (flèche F), l'effort est répercuté pratiquement sur la ligne horizontale médiane du connecteur femelle 108, si bien que ce dernier peut être séparé du connecteur mâle avec un effort dont l'orientation et la position sont optimales, sans risque de tordre les broches 206 du connecteur mâle.

On peut noter que, au cours de la phase initiale de l'extraction, les languettes de verrouillage 136 franchissent les bourrelets associés 142 simplement grâce à l'effort d'extraction dirigé selon la flèche F.

Lorsqu'une cartouche conforme à l'invention doit être mise en place dans un logement disponible, il suffit de la mettre en position dans ce dernier (le commencement de la pénétration des broches mâles 208 ayant lieu alors que le boîtier 100 est déjà partiellement inséré dans son logement) et d'exercer une pression adéquate au niveau de la partie inférieure de la face avant du boîtier, afin que l'effort s'exerce approximativement dans le plan horizontal médian des connecteurs. Dans ce cas, il est bien entendu préférable que le volet 110 ait été préalablement refermé contre la face avant du boîtier.

Mais il est également possible d'enficher la cartouche alors que le volet est ouvert et occupe approximativement la position illustrée sur la figure 3. Dans ce cas, la pression de mise en place, exercée sur le volet comme pour l'extraction mais en sens inverse, s'exerce à coup sûr dans le plan médian des connecteurs, ou au très proche voisinage de celui-ci.

Dans un cas comme dans l'autre, les nervures de coin 146 et les gorges associées 144 assurent un guidage optimal de la cartouche tout au long de son mouvement.

Ainsi, la présente invention propose une cartouche dont les moyens d'extraction n'augmentent l'encombrement ni en largeur, ni en hauteur, ni en profondeur dans leur position de rangement, et qui n'exigent pour le logement devant recevoir la cartouche aucun aménagement particulier (autres que les aménagements de verrouillage et de guidage décrits ci-dessus et applicables à tout type de cartouche) tendant à accroître son encombrement. En même temps, la cartouche conforme à l'invention permet, par une manoeuvre simple de sortie du volet, de disposer d'un organe de préhension aux fins d'extraction qui est pratique à utiliser, de par la grande surface de préhension offerte, et qui exerce la force d'extraction au droit des connecteurs, ce qui évite tout coïncement au faussage de ces derniers.

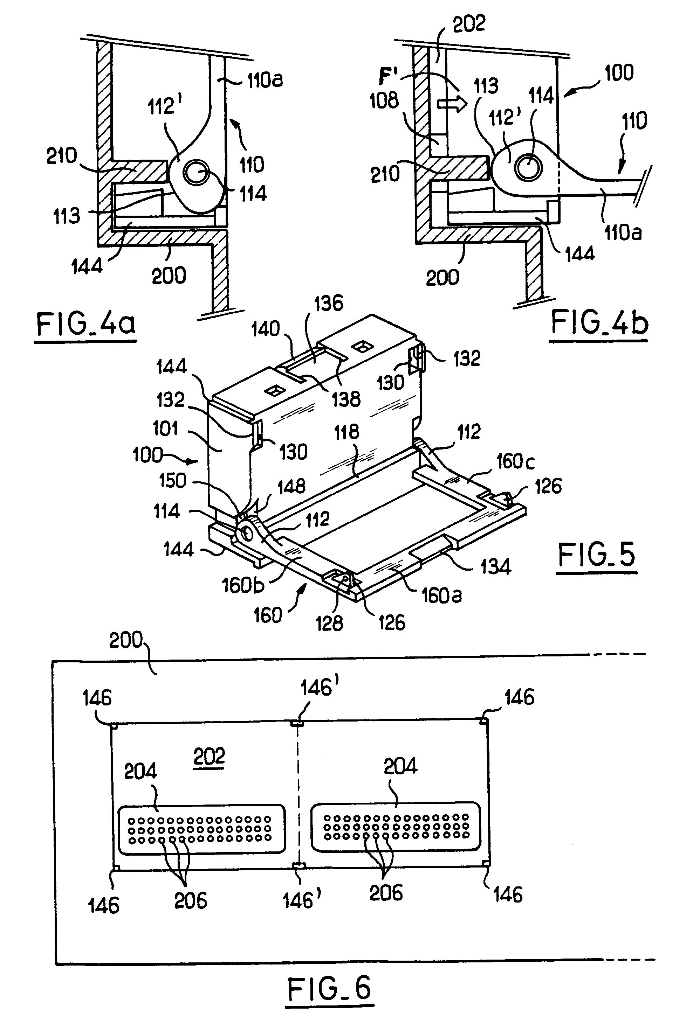

On a représenté sur les figures 4a et 4b une variante de réalisation d'un détail de la présente invention. Plus précisément, dans le but de faciliter encore l'extraction de la cartouche, les paliers par lesquels le volet 110 est fixé au boîtier 100, paliers qui sont désignés par la référence 112′ agissent lors du pivotement du volet pour créer un effort de direction appropriée. On peut ainsi observer que la surface extérieure 113 du palier 112′ présente un profil d'excentrique ou de came qui est au contact d'un élément, désigné par la référence 210, qui fait saillie à partir du fond du logement 202 associé et dont la face d'extrémité antérieure tient lieu de patin de came coopérant avec la surface de came 113.

Ainsi, lorsque le volet 110 est fermé, le dimensionnement est tel que la cartouche 100 peut être reçue intégralement dans son logement, comme le montre la figure 4a.

Mais à mesure que le volet 110 est ouvert aux fins de préhension pour l'extraction de la cartouche, le rayon local de la surface de came 113 s'accroît, ce qui a pour effet d'exercer entre l'axe 114 du boîtier et l'élément 210 formant patin une poussée horizontale qui provoque le début de l'extraction de la cartouche, par déplacement dans le sens de la flèche F′.

L'extraction de la cartouche est ainsi encore facilitée.

Il est à noter que, autant dans la forme de réalisation des figures 1 à 3 que dans sa variante des figures 4a et 4b, le volet 110 peut, en plus de sa fonction d'extraction, tenir lieu avantageusement de cache de protection pour des informations portées sur la face avant du boîtier, par le biais d'une étiquette adhésive ou autre, qui sont relatives au contenu de la mémoire morte. Ceci est particulièrement intéressant dans ces environnements industriels difficiles,où les automates programmables sont souvent implantés. Dans ce cas, afin de pouvoir visualiser ces informations sans libérer le volet, ce dernier pourra être réalisé en matière plastique transparente.

Une autre configuration possible consiste à disposer les informations "fabricant" sur la face avant du boîtier, tandis que la face extérieure du volet est réservée pour recevoir des informations"utilisateur".

On a représenté sur la figure 5, en perspective, une autre variante de réalisation de la présente invention. Dans cette variante, des éléments ou parties identiques ou similaires à ceux des réalisations précédentes sont désignés par les mêmes numéros de référence.

Comme on peut l'observer, le volet 110 est replacé ici par une anse 160, essentiellement en forme de "U", dont les extrémités libres des deux branches 160b et 160c portent les paliers 112. Les ergots de verrouillage 126 sont conservés, mais la zone de préhension de la forme de réalisation des figures 1 à 3 est remplacée, en ce qui concerne l'exercice de l'effort de traction, par la base 160a du "U".

Dans cette variante, bien qu'on ne l'ait pas illustré, il est possible de donner à la face avant du boîtier 101 un relief tel que l'anse, une fois rabattue, définisse avec ladite face une surface essentiellement plane. Plus précisément, on définira au pourtour de la face avant du boîtier un renfoncement en "U" renversé qui soit complémentaire de l'anse.

En référence maintenant à la figure 6, on a représenté en vue de face partielle un automate programmable susceptible de recevoir deux cartouches conformes à la présente invention.

Il comprend à cet effet un logement unique 202 d'une hauteur et d'une profondeur égales à celles des cartouches et d'une largeur égale au double de la largeur d'une cartouche.

On peut observer les deux ouvertures 204 laissant passer les broches 206 des deux connecteurs mâles respectifs et les nervures de guidage 146. A cet égard, une nervure rectangulaire unique 146', au milieu des faces supérieure et inférieure du logement, respectivement, peut guider et positionner à la fois la cartouche de gauche et la cartouche de droite.

Ainsi, comme on l'a indiqué plus haut, deux cartouches selon l'invention peuvent être étroitement juxtaposées (les axes 114 et les paliers 112 situés dans les renfoncements 148 ne débordant pas au-delà des faces latérales du boîtier), du fait que l'on fait appel à la troisième dimension, perpendiculaire au plan de la face avant de l'automate, pour les moyens d'extraction.

De façon préférée, le boîtier 101 et son volet 110 ou son anse 160 sont réalisés en une matière plastique moulée, le volet 110 étant le cas échéant transparent, comme on l'a indiqué plus haut.

## Revendications

1. Cartouche de mémoire amovible pour un équipement électronique telle qu'un automate programmable, du type comprenant un boîtier (101), une unité de mémoire (106) montée dans le boîtier et un connecteur allongé (108) fixé au boîtier, permettant l'interconnexion de ladite unité de mémoire avec l'équipement électronique et tenant lieu en même temps de moyen de fixation de la cartouche (100) dans un logement associé (202) de l'équipement (200), et des moyens de préhension prévus sur le boîtier pour permettre l'extraction de la cartouche par séparation du connecteur (108), caractérisée en ce que les moyens de préhension comprennent un organe plat (110;160) articulé sur un axe (114) situé en regard du connecteur et susceptible d'occuper une première position, contre le boîtier, et une seconde position, dégagée du boîtier, dans laquelle il peut être saisi pour exercer sur le boîtier un effort d'extraction s'exerçant au droit du connecteur (108).

2. Cartouche selon la revendication 1, caractérisée en ce que le boîtier (101) est de forme essentiellement rectangulaire et en ce que le connecteur (108) est disposé le long de l'un de ses bords horizontaux.

3. Cartouche selon la revendication 2, caractérisée en ce que l'organe plat est constitué par un volet (110) ayant une largeur sensiblement égale à celle du boîtier (100) et une hauteur légèrement inférieure, des liaisons pivotantes (112, 114) étant prévues entre le volet et les faces latérales du boîtier au voisinage des extrémités respectives du connecteur (108).

4. Cartouche selon la revendication 3, caractérisée en ce que le volet comprend sur au moins l'une de ses surfaces une zone de préhension (124) comportant des reliefs.

5. Cartouche selon l'une des revendications 3 et 4, caractérisée en ce qu'une région de la face avant du boîtier, située en vis-à-vis du volet (110) lorsque celui-ci occupe ladite première position, tient lieu de support d'informations.

6. Cartouche selon la revendication 5, caractérisée en ce que le volet (110) est transparent.

7. Cartouche selon la revendication 5, caractérisée en en ce que la face extérieure du volet (110) tient lieu également de support d'informations.

8. Cartouche selon la revendication 2, caractérisée en ce que l'organe plat est constitué par une anse (160) en forme générale de "U", des liaisons pivotantes (112, 114) étant prévues entre les extrémités libres des branches (160b, 160c) du "U" et les faces latérales du bottier au voisinage des extrémités respectives du connecteur (108).

9. Cartouche selon l'une des revendications 3 à 8, caractérisée en ce que les paliers (112') comportent une surface extérieure à profil de came (113) qui coopère avec un élément formant patin (210) monté fixe dans ledit logement (202), de telle sorte que le passage de l'organe plat (110;160) de sa première à sa seconde position engendre entre le boîtier (101) et l'équipement un effort et de poussée déterminant une phase initiale de l'extraction.

10. Cartouche selon l'une des revendications 3 à 9, caractérisée en ce que lesdits axes (114) et lesdits paliers (112) sont reçus dans des renfoncements (148) formés dans les faces latérales du boîtier (101), de manière à ne pas déborder au-delà desdites faces latérales.

11. Cartouche selon l'une des revendications 1 à 10, caractérisée en ce que l'organe plat (110;160) et le boîtier (101) comportent des moyens de verrouillage élastique mutuel (126, 128, 130, 132) dudit organe plat dans ladite première position.

12. Cartouche selon la revendication 11, caractérisée en ce que l'organe plat (110; 160) comporte une encoche (134) offrant une zone de prise pour un ongle ou un outil en vue du déverrouillage desdits moyens de verrouillage élastique (126, 128, 130, 132).

13. Equipement électronique, tel qu'un automate programmable, caractérisé en ce qu'il comprend, dans un boîtier (200), au moins un logement (202) équipé d'un connecteur (208), dans lequel est reçue étroitement une cartouche (100) selon l'une quelconque des revendications précédentes.

14. Equipement électronique selon la revendication 13, caractérisé en ce que des moyens de verrouillage élastique mutuel (136, 140, 142) sont prévus entre le boîtier (101) de la cartouche et au moins une paroi du logement (202).

15. Equipement électronique selon l'une des revendications 13 et 14, caractérisé en ce qu'il comprend un logement unique (202) qui reçoit côte-à-côte deux cartouches (100).

16. Equipement électronique selon la revendication 15, caractérisé en ce que des moyens de guidage et de positionnement complémentaires (144, 146) sont prévus sur le boîtier (101) de la cartouche et sur les parois du logement (202).

17. Equipement électronique selon la revendication 16, caractérisé en ce que les moyens de guidage et de positionnement comprennent des gorges (144) prévues aux coins de chaque boîtier (101) de cartouche et des nervures complémentaires (146) formées sur les parois du logement (202), dont certaines (146') sont communes aux deux cartouches.

**Patentansprüche**

1. Austauschbare Speicherkassette für eine elektronische Anlage, z.B. einen programmierbaren Automaten, mit einem Gehäuse (101), einer im Gehäuse angeordneten Speichereinheit (106) und einer am Gehäuse befestigten, langgestreckten Steckverbindung (108), welche die Speichereinheit mit der elektronischen Anlage betriebsmäßig zu verbinden gestattet und gleichzeitig als Halterungsvorrichtung der Speicherkassette (100) in einer entsprechenden Aufnahme (202) der Anlage (200) dient, sowie mit auf dem Gehäuse angeordneten Griffmitteln, um durch Auftrennung der Steckverbindung (108) die Herausnahme der Kassette zu ermöglichen, dadurch gekennzeichnet, daß die Griffmittel ein Flachteil (110;160) aufweisen, welches an einer der Steckverbindung gegenüberliegenden Achse (114) drehbar ist und eine gehäusenahe erste Position sowie eine gehäuseferne zweite Position einzunehmen vermag, in der es sich greifen läßt, um auf das Gehäuse eine im Bereich der Steckverbindung (108) wirkende Zugkraft auszuüben.

2. Kassette nach Anspruch 1, dadurch gekennzeichnet, daß das Gehäuse (101) eine im wesentlichen rechtwinklige Form aufweist, und daß die Steckverbindung (108) längs einer seiner horizontalen Ränder angeordnet ist.

3. Kassette nach Anspruch 2, dadurch gekennzeichnet, daß das Flachteil durch eine Klappe (110) gebildet wird, welche eine im wesentlichen gleiche Größe wie das Gehäuse (100) und eine etwas geringere Höhe aufweist, wobei Gelenkverbindungen (112,114) zwischen der Klappe und den Seitenflächen des Gehäuses nahe der jeweiligen Endbereiche der Steckverbindung (108) angeordnet sind.

4. Kassette nach Anspruch 3, dadurch gekennzeichnet, daß die Klappe auf zumindest einer ihrer Seiten einen Griffbereich (124) mit Reliefstruktur besitzt.

5. Kassette nach einem der Ansprüche 3 und 4, dadurch gekennzeichnet, daß ein Bereich der Vorderseite des Gehäuses, welcher der Klappe (110) gegenüberliegt, wenn diese die erste Position einnimmt, einen Daten- bzw Informationsträgerplatz bildet.

6. Kassette nach Anspruch 5, dadurch gekennzeichnet, daß die Klappe (110) transparent ist.

7. Kassette nach Anspruch 5, dadurch gekennzeichnet, daß die Außenseite der Klappe (110) ebenfalls einen Daten- bzw. Informationsträgerplatz bildet.

8. Kassette nach Anspruch 2, dadurch gekennzeichnet, daß das Flachteil durch einen Griff (160) mit etwa U-Form gebildet wird, wobei Gelenkverbindungen (112,114) zwischen den freien Enden der U-Schenkel (160b,160c) und den Seitenflächen des Gehäuses nahe der jeweiligen Endbereiche der Steckverbindung (108) angeordnet sind.

9. Kassette nach einem der Ansprüche 3 bis 8, dadurch gekennzeichnet, daß die Lagerteile (112') eine Außenfläche mit Nockenprofil besitzen, die mit einem Element, welches als ein fest in der Aufnahme (202) angeordnetes Gleitstück (210) ausgebildet ist, zusammenwirkt, derart, daß die Verstellung des Flachteiles (110;160) aus seiner ersten in seine zweite Position zwischen dem Gehäuse (101) und der Anlage eine Schubkraft sowie Schubwirkung erzeugt, durch die eine Anfangsphase der Herausnahmebewegung bewirkt wird.

10. Kassette nach einem der Ansprüche 3 bis 9, dadurch gekennzeichnet, daß die Achsen (114) und die Lagerteile (112) in Aussparungen (148), welche in den Seitenflächen des Gehäuses (101) ausgebildet sind, aufgenommen sind, ohne diese Seitenflächen zu überragen.

11. Kassette nach einem der Ansprüche 1 bis 10, dadurch gekennzeichnet, daß das Flachteil (110;160) und das Gehäuse (101) Mittel (126,128,130,132) zur elastischen Verriegelung aneinander bei in der ersten Position befindlichem Flachteil besitzen.

12. Kassette nach Anspruch 11, dadurch gekennzeichnet, daß das Flachteil (110;160) eine Aussparung (134) besitzt, die eine Eingriffzone für einen Fingernagel oder ein Werkzeug zur Entriegelung der elastischen Verriegelungsmittel (126,128,130,132) bildet.

13. Elektrische Anlage, z.B. programmierbarer Automat, dadurch gekennzeichnet, daß sie in einem Gehäuse (200) zumindest eine mit einer Steckverbindung (208) versehene Aufnahme (202) besitzt, in der eine Kassette (100) nach einem der vorangehenden Ansprüche paßgenau aufgenommen wird.

14. Anlage nach Anspruch 13, dadurch gekennzeichnet, daß Mittel (136,140,142) zur gegenseitigen elastischen Verriegelung zwischen dem Gehäuse (101) und mindestens einer Wand der Aufnahme (202) vorgesehen sind.

15. Anlage nach einem der Ansprüche 13 und 14, dadurch gekennzeichnet, daß die Anlage eine einzige Aufnahme (202) besitzt, die zwei Kassetten (100) unmittelbar nebeneinander aufnimmt.

16. Anlage nach Anspruch 15, dadurch gekennzeichnet, daß komplementäre Führungs- und Positionierelemente (144,146) auf dem Gehäuse (101) und den Wänden der Aufnahme (202) angeordnet sind.

17. Anlage nach Anspruch 16, dadurch gekennzeichnet, daß die Führungs- und Positionierelemente Auskehlungen (144) an den Eckbereichen jedes Kassettengehäuses (101) und an den Wänden der Aufnahme (202) ausgebildete komplementäre Rippen (146) aufweisen, von denen einige (146) für zwei Kassetten gemeinsam vorgesehen sind.

## Claims

1. A removable memory cartridge for electronic equipment such as a programmable automaton, the cartridge being of the type comprising a box (101), a memory unit (106) mounted in the box, and an elongate connector (108) fixed to the box and enabling said memory unit to be interconnected with the electronic equipment while simultaneously constituting means for fixing the cartridge (100) in an associated housing (202) of the equipment (200), the box being provided with grasping means to enable the cartridge to be extracted by separating the connector (108), characterized in that the grasping means comprise a flat member (110; 160) hinged about an axis (114) located opposite the connector and suitable for occupying a first position against the box, and a second position away from the box in which said flat member may be grasped in order to exert an extraction force on the box acting level with the connector (108).

2. A cartridge according to claim 1, characterized in that the box (101) is essentially rectangular in shape and in that the connector (108) is disposed along one of its horizontal edges.

3. A cartridge according to claim 2, characterized in that the flat member is constituted by a flap (110) whose width is substantially equal to that of the box (100) and whose height is slightly smaller, with pivoting connections (112, 114) being provided between the flap and the side faces of the box in the vicinity of the respective ends of the connector (108).

4. A cartridge according to claim 3, characterized in that the flap includes a grasping zone (124) on at least one of its faces, said zone including relief.

5. A cartridge according to claim 3 or 4, characterized in that a region of the front face of the box situated facing the flap (110) when the flap is occupying said first position, serves as a medium on which information is marked.

6. A cartridge according to claim 5, characterized in that the flap (110) is transparent.

7. A cartridge according to claim 5, characterized in that the outside face of the flap (110) also serves as a medium on which information is marked.

8. A cartridge according to claim 2, characterized in that the flat member is constituted by a generally U-shaped handle (160) with pivoting connections (112, 114) being provided between the free ends of the branches (160b, 160c) of the U-shape and the side faces of the box in the vicinity of respective ends of the connector (108).

9. A cartridge according to any one of claims 3 to 8, characterized in that each bearing (112') includes an outside surface having a cam profile (113) which cooperates with a shoe-forming element (210) fixed in said housing (202) in such a manner that moving the flat member (110; 160) from its first position to its second position causes a thrust force to be exerted between the box (101) and the equipment, thereby determining an initial stage of extraction.

10. A cartridge according to any one of claims 3 to 9, characterized in that said bearings (112) and shafts (114) embodying said axes are received in setbacks (148) formed in the side faces of the box (101) so as to avoid projecting beyond said side faces.

11. A cartridge according to any one of claims 1 to 10, characterized in that the flat member (110; 160) and the box (101) include mutual resilient locking means (126, 128, 130, 132) for locking said flat member in said first position.

12. A cartridge according to claim 11, characterized in that the flat member (110; 160) includes a notch (134) providing a grasping zone for a fingernail or a tool in order to unlock said resilient locking means (126, 128, 130, 132).

13. Electronic equipment such as a programmable automaton, characterized in that it includes, in a box (200), at least one housing (202) fitted with a connector (208), said housing closely receiving a cartridge (100) according to any preceding claim.

14. Electronic equipment according to claim 13, characterized in that mutual resilient locking means (136, 140, 142) are provided between the box (101) of the cartridge and at least one of the walls of the housing (202).

15. Electronic equipment according to claim 13 or 14, characterized in that it includes a single housing (202) which receives two cartridges (100) side-by-side.

16. Electronic equipment according to claim 15, characterized in that complementary guidance and positioning means (144, 146) are provided on the box (101) of the cartridge and on the walls of the housing (202).

17. Electronic equipment according to claim 16, characterized in that the guidance and positioning means comprise grooves (144) provided at the corners of each cartridge box (101) and complementary ribs (146) formed on the walls of the housing (202), with some of said grooves (146') being common to both cartridges.

FIG_1

FIG_2

FIG_3

FIG.4a

FIG.4b

FIG.5

FIG.6